# EUROPEAN PATENT APPLICATION

(11) **EP 3 611 518 A1**
(43) Date of publication of application: **19.02.2020**
(21) Application number: 18189094.8
(22) Date of filing: 15.08.2018
(51) Int. Cl.: G01R 15/04, G01R 15/06

(54) **SENSOR MAT**

(71) Applicant: 3M Innovative Properties Company, Saint Paul, MN 55133-3427 (US)
(72) Inventor: Gravermann, Mark, 41812 Erkelenz (DE)
(74) Representative: Müller, Bruno

(57) **Abstract**

Sensor mat (1) comprising an electrically insulating, flexible insulation body (10) and a voltage divider assembly (20), embedded in the insulation body. The divider assembly comprises a plurality of discrete impedance elements, connected in series to be operable as a voltage divider for sensing a voltage of a MV/HV power conductor in a power distribution network.

The insulation body has the shape of a mat and comprises an outer mounting surface (110) for affixing the sensor mat on a support surface.

## Description

This disclosure relates to voltage sensors for sensing voltages of medium-voltage or high-voltage power conductor in power distribution networks. In particular, it relates to voltage dividers for such sensors, to cable accessories and power networks comprising such voltage dividers, and to processes for manufacturing such voltage sensors.

Voltage sensors for medium-voltage (MV) or high-voltage (HV) power conductors, such as bus bars or power cables, are mostly arranged close to the actual power conductors, in order to avoid longer, bulky connections between the sensors and the power conductors and elements for their electrical insulation. Certain voltage sensors are threaded over a cable, such as the sensor described in the international patent application WO 2013/186069 A1.

Other voltage sensors are arranged next to a cable, for example the sensor described in the European patent application EP 3 223 024 A1, where a voltage divider assembly is arranged in a separate cavity of an elastic sleeve surrounding a power conductor.

Fixation of these traditional sensors on - or next to- the power conductor requires threading over the conductor, e.g. threading over a cable. Threading the sensor over the cable requires the cable end to be accessible and that no cable accessories be mounted on the cable end. These conditions are not always fulfilled, so that fixation of these sensors requires some effort. Also, the traditional sensors described above do not allow retrofitting of a sensor on an existing and connected conductor without disconnecting the conductor. Further, once mounted on or next to the conductor, those traditional sensors cannot easily be repositioned or replaced. Also, the traditional sensors described above are designed for being threaded over power conductors having outer diameters within a certain range, and having circular cross sections, so that for a variety of conductors of different cross section and diameter, a certain number of different-sized sensors had to be kept in store. Lastly, the traditional sensors required a cable to be mounted on.

The present disclosure attempts to address some of these shortcomings. It provides a sensor mat comprising an electrically insulating, flexible insulation body and a divider assembly, embedded in the insulation body, wherein the divider assembly comprises a plurality of discrete impedance elements, electrically connected in series with each other such as to be operable as a voltage divider for sensing a voltage of a MV/HV power conductor in a power distribution network, characterized in that the insulation body has the shape of a mat and comprises a outer mounting surface for affixing the sensor mat on a support surface.

Due to the mounting surface of the insulation body and its flexibility, the sensor mat can be affixed to power conductors, e.g. to a sheath of a power cable, without threading, because the insulation body can be mounted on the power conductor, e.g. on a sheath of a power cable, largely independent of the conductor's cross section and diameter. The sensor mat can thus be affixed to conductors at locations far from their ends, or when an end is not accessible or is occupied by other accessories. By the same token, retrofitting a sensor mat according to the present disclosure to an existing power conductor, or replacing a sensor mat is easier and does not require disconnecting of the power conductor. The flexibility of the insulation body facilitates affixing the sensor mat to flat or one-dimensionally curved support surfaces of different radii. In certain scenarios, the sensor mat of the present disclosure does not require a cable for mounting, but can be mounted on a different support.

The term "medium voltage" or "MV" as used herein refers to a voltage in the range of 1 kV to 72 kV, whereas the term "high voltage" or "HV" refers to a voltage of more than 72 kV.

The sensor mat of the present disclosure comprises a flexible insulation body and a divider assembly. The term "flexible" is used in its regular, common meaning of "flex-able". The insulation body can thus be bent or flexed, similar to like a sheet can be bent or flexed.

Because the insulation body has the shape of a mat, it can be placed on a flat support surface, or on a support surface that is curved in one dimension, i.e. curved as the curved surface of a cylinder. Due its flexibility, it can also be wrapped around certain supports, such as around skirt-less termination bodies.

The flexibility of the insulation body provides that the insulation body has a certain conformability, i.e. it can take the shape of a surface on which it is placed, within certain limits which depend on the thickness of the insulation body and the mechanical properties of the material from which it is made. A flexible insulation body, as described herein, is flexible enough to be wrapped around cylindrical supports having diameters of 15 centimetres (cm) or less. Insulation bodies that can only be wrapped around cylindrical supports having diameters of 50 cm or more are not considered to be flexible.

A flexible insulation body may be flexible in only one direction and not be flexible in another direction.

Elasticity is considered herein to refer to the compressibility or expandability of a body, and is therefore considered to be different from flexibility. The flexible insulation body may be elastic or non-elastic. It may comprise, or be made of, an elastic material, such as an elastomer, a silicone material, rubber or EPDM (ethylene propylene diene monomer).

The insulation body of a sensor mat according to the present disclosure has the shape of a mat. "Mat" herein refers to a flexible flat body, delimited by two major surfaces extending in width and length directions and spaced from each other in a thickness direction, in which the thickness is considerably smaller than its length and width. A mat is considered to be different from a sheet in that the thickness of a mat may vary in width and length directions. A mat may thus have an uneven surface or it may have surface features. A body having a thickness of less than 1/1000 (or 0.1%) or greater than 3/4 (or 75%) of its longest extension in width or length directions is not considered a mat in the present disclosure.

Typical insulation bodies according to the present disclosure have a thickness of between about 1 millimetre (mm) and about 20 mm, with their longest extension in width and length being between about 10 cm and 50 cm.

The shape of mats according to the present disclosure in the width-length plane ("footprint") is not particularly limited. Such mats may have, for example, rectangular or square footprints, circular or elliptical footprints, or even triangular, hexagonal or irregular footprints. The footprint may be tailored according to the size and shape of the support surface on which the sensor mat is to be affixed.

In a particular embodiment, the insulation body thus has the shape of a mat of a rectangular footprint of 10 cm width, 20 cm length, and of 1 cm thickness.

The insulation body of a sensor mat according to the present disclosure provides electrical insulation for the divider assembly embedded in it. Since the divider assembly is electrically connected to the MV/HV power conductor in order to sense its voltage, at least a portion of it is on elevated (i.e. medium or high) voltage. Insulation of appropriate thickness and shape is required to reduce the risk of electrical discharges between a portion of the divider assembly on elevated voltage and an element on lower voltage or on ground in the vicinity of the divider assembly.

Suitable materials for the insulation body are electrically insulating materials like natural rubber, silicone rubber, or EPDM, for example.

Molding is a cost-effective way to make electrically insulating and flexible elements, and allows accurate control of the molding material composition and of geometric shape. The insulation body may be a molded body. The molding material is caused to dry and solidify to form the insulation body. The insulation body may be, or comprise, molded silicone or molded EPDM, for example.

The insulation body can be molded such that it comprises a cavity for accommodating the divider assembly. After the insulation body is formed, the divider assembly may be accommodated, and thereby embedded, in the insulation body, e.g. by pushing the divider assembly into the cavity.

The insulation body may be a molded body, overmolded over the divider assembly. Overmolding refers to a process wherein liquid or viscous insulating material is poured over and around the divider assembly. The insulating material is then caused to dry and solidify to form the insulation body, in which the divider assembly is then embedded. Overmolding may be advantageous in that the liquid or viscous insulating material gets in direct intimate contact with the outer surface of the divider assembly. Thereby, overmolding typically results in less and/or smaller voids, gaps and other air-filled cavities being formed between the divider assembly and an inner surface of the insulation body, which in turn reduces risk of electrical discharges. After overmolding, the insulation body comprises a cavity in which the divider assembly is accommodated, i.e. embedded.

Depending on the materials used for the encapsulation body and the insulation body, it may be advantageous to provide the surface of the encapsulation body with an adhesion promoter or primer before overmolding the divider assembly with material that will, after solidifying, form the insulation body. Such an adhesion promoter may facilitate adhesion between the insulation body and the divider assembly.

Hence independent from the insulation body being molded independently form the divider assembly, or overmolded over the divider assembly, in certain embodiments, the insulation body is a molded body and comprises a cavity for accommodating the divider assembly therein. In certain of those embodiments, the insulation body is a molded body, overmolded over the divider assembly.

The elevated voltage with which the sensor mat is used will determine the requirements for electrical insulation provided by the insulation body, and a higher voltage will normally require a larger and thicker insulation body. Independent of how it is made, the mat-shaped insulation body may have a thickness, measured orthogonally to the mounting surface, of between about 5 mm or 10 mm and about 50 mm. The thickness may be uniform across the insulation body.

Alternatively, the thickness of the insulation body may not be uniform. In this case the insulation body may have a lowest thickness of 5 mm or more anywhere, and/or it may have a greatest thickness of 50 mm or even 70 mm anywhere.

The insulation body may have different cross sections. The term "cross section" of the insulation body refers to a section taken in a plane orthogonal to the outer mounting surface of the insulation body. The insulation body may, for example, have a rectangular cross section, a square cross section, a semi-circular cross section, or a semi-elliptical cross section.

Where the divider assembly has an elongated shape defining a length direction, the cross section may be taken in a plane orthogonal to the outer mounting surface of the insulation body and orthogonal to the length direction of the divider assembly. In this case, the insulation body may have, for example, a rectangular cross section, a square cross section, a semi-circular cross section, or a semi-elliptical cross section.

The outer mounting surface of the insulation body facilitates affixing the sensor mat to a support surface. The mounting surface can provide an extended surface contact between the insulation body and a support surface and thereby provide for a reliable attachment of the sensor mat and for a stable orientation of the sensor mat relative to the support surface.

Generally, the outer mounting surface may be any of the outer surfaces of the insulation body that is large enough to affix the sensor mat to a support surface. In many embodiments, the outer mounting surface is flat. The mounting surface may be a major surface of the insulation body. Where the insulation body comprises two opposed major surfaces, parallel to each other or not, the mounting surface may be one of the opposed major surfaces.

The outer mounting surface facilitates affixing or attaching the sensor mat to another element. For secure fixation or attachment, the mounting surface must have a minimum size. Depending on the weight of the sensor mat, the size of the mounting surface may be greater than 50 square centimetres (cm²). The size of the outer mounting surface is certainly greater than 5 cm².

The contour, i.e. the "footprint", of the outer mounting surface is not essential. It may be chosen according to the size or shape of the support surface to which the sensor mat is to be affixed. Depending on the circumstances, the outer mounting surface may have a rectangular, square, elliptical, circular, hexagonal, trapezoid or triangular contour.

The outer mounting surface of the insulation body may be flat. This refers to its shape when no external forces are applied, in particular when the insulation body is not flexed, and when the insulation body is not compressed or expanded.

The term "outer mounting surface" refers to the mounting surface being, or being comprised in, an external surface of the insulation body, as opposed to an inner surface.

The sensor mat according to the present disclosure can be affixed to a support surface. The support surface may be, for example, a surface of a wall, a surface of an inner or outer wall of a switchgear or of a different type of cabinet, a surface of a MV/HV power cable, a surface of a HV/MV power cable accessory such as a cable termination, a cable splice, or a cable connector.

The support surface may be a flat surface, but alternatively the support surface may be a curved surface, such as a one-dimensionally curved surface (an example being the curved surface of a cylinder), or a two-dimensionally curved surface (an example being the curved surface of a sphere).

In some embodiments, the outer mounting surface of the insulation body is flat. This does not exclude that the sensor mat, via the outer mounting surface, can be affixed to support surfaces that are not flat, that are curved, or that are irregularly shaped. In particular, affixing to structured support surfaces is not excluded.

Where the sensor mat is affixed to a conductive support surface, the voltage sensing accuracy may be reduced. Also, electrical discharges may be more likely to occur between the divider assembly and the support surface through the insulation body, depending on the electrical potential of the support surface and the thickness of the insulation body. Hence advantageously the support surface is a non-conductive surface.

The divider assembly according to the present invention comprises a plurality of (e.g. two, three, four or more) discrete impedance elements which are electrically connected in series with each other such as to be operable as a voltage divider for sensing a voltage of a power conductor in a power distribution network.

The divider assembly may generally have any suitable shape. However, in certain embodiments of the present disclosure, the divider assembly has an elongated shape, defining two opposed end portions. The impedance elements of the divider assembly may be arranged in a linear manner. The impedance elements may thus form a straight chain of impedance elements, a "divider chain".

The divider assembly is embedded in the insulation body. The term "embedded" refers to the divider assembly being surrounded by the insulation body and a major portion of its outer surface being in mechanical contact with an inner surface of the insulation body. A rod-shaped divider assembly, for example, being pushed completely into a tight-fitting cavity of the insulation body, is considered to be embedded in the insulation body. A divider assembly, for example, being molded into an insulation body, is considered to be embedded in the insulation body. As a further example, where the insulation body is overmolded over the complete divider assembly, the divider assembly is considered to be embedded in the insulation body.

Wires leading to or form the embedded divider assembly are obviously not completely embedded in the insulation body, but one end of such wires extends to the outside of the insulation body, so that the divider assembly can be electrically connected.

Where the divider assembly has an elongated shape, this shape defines a length direction of the divider assembly. In many embodiments of the present disclosure the insulation body has the shape of a mat having a rectangular contour being delimited by a straight edge. It may be space-saving to have the elongated divider assembly embedded in the insulation body such that its length direction is oriented parallel to the straight edge. Therefore, in certain embodiments, the insulation body has a rectangular contour delimited by at least one straight edge, and the divider assembly has an elongated shape defining a length direction and is arranged such that its length direction is oriented parallel to the straight edge.

The divider assembly may be electrically connected between the power conductor and low voltage or electrical ground. A low voltage, as used herein, is a voltage of a few Volt, typically less than 100 Volt. An impedance element may be, for example, a resistor, a capacitance or an inductance. A plurality of discrete impedance elements may comprise one resistor and one or more capacitors. A plurality of discrete impedance elements may comprise one resistor and one or more inductances. A plurality of discrete impedance elements may comprise one inductance and one or more capacitors. Generally, the plurality of discrete impedance elements may comprise one or more resistors, and/or one or more capacitors and/or one or more inductances. In certain embodiments, the discrete impedance elements are discrete capacitors. In certain other embodiments, the discrete impedance elements are discrete resistors. Resistors, capacitors and inductances are particularly suitable elements to form a voltage divider, because they are readily available at moderate cost. Also, their electrical properties are generally precisely specified.

The plurality of discrete impedance elements may be mechanically connected in series, e.g. such as to form a chain, e.g. a straight chain of impedance elements.

The divider assembly may be rigid. This may facilitate pushing the divider assembly into a cavity in the insulation body. Alternatively, the divider assembly may be flexible, e.g. bendable. A flexible divider assembly may be able to follow any deformations of the sensor mat.

A first impedance element of the plurality of discrete impedance elements may have a high-voltage contact for electrical connection to the power conductor on elevated voltage, e.g. to an inner conductor of a power cable.

A second impedance element of the plurality of discrete impedance elements may have a low-voltage contact for electrical connection to low voltage or to electrical ground. Generally, the low-voltage contact may be arranged such as to be accessible for electrical contacting from outside the insulation body. Where the divider assembly has an elongated shape comprising a first end portion and an opposed second end portion, and where the high-voltage contact is arranged at the first end portion, the low-voltage contact may be arranged at the second end portion of the divider assembly. A ground wire may be electrically connected to the low-voltage contact for making the voltage of the low-voltage contact available outside of the insulation body.

The divider assembly may comprise a midpoint access contact for picking up a divided voltage from the plurality of discrete impedance elements. The midpoint access contact may be electrically arranged between the first and the second impedance element. A signal wire may be electrically connected to the midpoint access contact for making the voltage of the midpoint access contact available outside of the insulation body.

The plurality of discrete impedance elements connected in series may be arranged in a straight chain. Since the voltage along the plurality of impedance elements generally drops from the high-voltage contact to the low-voltage contact, a linear chain geometry provides for a maximum distance between two discrete impedance elements that are on different voltages and thereby reduces the risk of electrical discharges between impedance elements or between conductive wires or traces connecting the impedance elements with their respective neighbours.

The outer shape of the divider assembly is generally independent of the shape formed by the arrangement of the discrete impedance elements.

The plurality of discrete impedance elements are connected in series such as to be operable as a voltage divider for sensing an elevated voltage. They may be electrically connected with each other, i.e. with one two adjacent discrete impedance elements, by wires or by conductive traces on a printed circuit board ("PCB") or by soldering material on a PCB. In certain embodiments, the divider assembly comprises a printed circuit board for supporting the plurality of discrete impedance elements. Each impedance element may comprise two contacts for connecting it electrically.

The plurality of discrete impedance elements may be arranged on a flexible printed circuit board. This may facilitate deformation and bending of the divider assembly as the sensor mat is deformed or bent, with less risk of the divider assembly being damaged by the deformation or bending, and thus increase the reliability of the sensor mat. In particular, arrangement on a flexible circuit board may reduce the risk of damage and failure when the insulation body is bent.

Alternatively, the plurality of discrete impedance elements may be arranged on a rigid printed circuit board. This may be advantageous in that the divider assembly may have a greater mechanical stiffness, which allows to push the divider assembly into a cavity in the insulation body more easily and with less risk of damage when assembling a sensor mat according to the present disclosure. Also, a rigid PCB may render the divider assembly more stable and rugged, so that distortions of the insulation body do not affect the discrete impedance elements.

As a further alternative, the plurality of discrete impedance elements may be unsupported, or free-hanging, i.e. not be arranged on a support, e.g. on a PCB. Such divider assemblies may be very cost-effective to manufacture as no support structure is required. They may also be particularly space-saving, because no space for a PCB needs to be provided. An unsupported, free-hanging plurality of discrete impedance elements may be overmolded with material forming the insulation body. After solidifying, the insulation body stabilizes the discrete impedance elements mechanically.

Alternatively, an unsupported, free-hanging plurality of discrete impedance elements may be encapsulated in an encapsulation body. The encapsulation body then stabilizes the discrete impedance elements mechanically.

The plurality of discrete impedance elements may be arranged on the PCB in a linear manner such as to form a straight chain of impedance elements, a "divider chain".

The PCB may be a single-layer or a multi-layer PCB. Single-layer PCBs are typically cost-effective, while multi-layer PCBs may allow to have conductive traces between discrete impedance elements buried and thereby protected.

Creepage currents may flow along a surface of the insulation body, from a portion located closer to the power conductor on elevated voltage towards another portion located closer to electrical ground, and in particular from a point where an element on elevated voltage, such as a high-voltage wire, enters the insulation body to a point where an element on ground or lower voltage, such as a ground wire, enters the insulation body. Protrusions in the expected path of the creepage current can prolong the path for these currents and thereby reduce them. In certain embodiments, the sensor mat therefore further comprises a skirt, protruding from a major surface of the insulation body, for reducing creepage currents over that major surface. The skirt may be integrally formed with the insulation body. Alternatively, the skirt may be a separate element, attached to the insulation body.

The outer mounting surface may be affixed to the support surface in various ways. In certain embodiments, the outer mounting surface is affixed to the support surface by screws.

In other embodiments, the outer mounting surface is formed by a layer of a first component of a two-component mechanical fastening system, such as a system sometimes referred to as Velcro™, which can engage with a corresponding layer of a second component of the two-component mechanical fastening system on the support surface, and thereby affix the sensor mat on the support surface. Mechanical fastening systems allow for a releasable and reclosable fixation of the sensor mat to the support surface.

In yet other embodiments, the outer mounting surface is formed by a layer of adhesive, e.g. a pressure-sensitive adhesive. The layer of adhesive can be made to adhere to the support surface and thereby affix the sensor mat on the support surface. Adhesive is a cost-effective and reliable way for affixing the sensor mat.

The adhesive may be a removable adhesive. The sensor mat may thus be easily removed from the support surface when the voltage sensor is not required any more.

For sensing a voltage of a MV/HV power conductor, the divider assembly - and in particular the impedance elements - must be electrically connected to the power conductor. This connection may be done via a first wire ("high-voltage wire") which may be, at one end, electrically connected to one of the impedance elements. At its other end it may be connectable to the power conductor. The sensor mat may thus comprise a high-voltage wire for electrical connection of the divider assembly to the power conductor. A first end of the high-voltage wire may be arranged inside the insulation body. A first end of the high-voltage wire may be mechanically and electrically connected to a high-voltage contact of the divider assembly. A second, opposed end of the high-voltage wire may be accessible outside the insulation body.

So, in certain embodiments, the divider assembly comprises a high-voltage wire, electrically connected to the plurality of discrete impedance elements, for electrically connecting the discrete impedance elements to the power conductor.

Similarly, the divider assembly - and in particular the impedance elements - may be electrically connected to electrical ground. This ground connection may be done via a second wire ("ground wire") which may be, at one end, electrically connected to one of the impedance elements. At its other end it may be connectable to an element on electrical ground outside the sensor mat. The sensor mat may thus comprise a ground wire for electrical connection of the divider assembly to electrical ground. A first end of the ground wire may be arranged inside the insulation body. A first end of the ground wire may be mechanically and electrically connected to a ground contact of the divider assembly. A second, opposed end of the ground wire may be accessible outside the insulation body.

The voltage divided by at least some of the discrete impedance elements varies proportionally with the voltage of the power conductor. This is the principle of voltage dividers and voltage-dividing voltage sensors. The divided voltage or "signal voltage" may be picked up between two adjacent discrete impedance of the plurality of impedance elements. A third wire, a "signal wire", may be used to transmit the signal voltage to the outside of the insulation body. The signal wire may be, at one end, electrically connected between two of the impedance elements. At its other end it may be connectable to electronic circuitry for processing the signal voltage, for determining the voltage of the power conductor, or for displaying the signal voltage. A first end of the signal wire may be arranged inside the insulation body. A first end of the signal wire may be mechanically and electrically connected to a signal contact of the divider assembly. A second, opposed end of the signal wire may be accessible outside the insulation body.

The divider assembly may comprise an electrically insulating encapsulation body in which the plurality of discrete impedance elements is encapsulated. Encapsulating the impedance elements in an encapsulation body may provide additional electrical insulation of the impedance elements against each other and against the remainder of the sleeve. The encapsulation body may also provide additional protection of the impedance elements against mechanical impacts like abrasion or chemical or environmental impacts.

The encapsulation body may be rigid. A rigid encapsulation body may provide for a higher stiffness of the divider assembly and facilitate insertion of the divider assembly into a cavity of the insulation body. The encapsulation body may comprise a smooth outer surface. Such a smooth outer surface may reduce the number and size of voids between the divider assembly and the inner wall of a cavity in the insulation body, when the divider assembly is arranged in the cavity.

The encapsulation body may comprise, or consist of, a resin. The resin may be a hardened resin. The hardened resin may be transparent. This may facilitate visual inspection of the impedance elements, when the divider assembly is removed from the cavity. Alternatively, the hardened resin may be opaque, such as to prevent the impedance elements (and a PCB, if present) from being seen and examined. Independent from comprising a resin or not, the encapsulation body may be transparent for allowing visual inspection of the plurality of discrete impedance elements, or the encapsulation body may be opaque for prohibiting visual inspection of the plurality of discrete impedance elements.

The divider assembly may be removable from the insulation body. The divider assembly or the insulation body or both may be adapted to facilitate removal, e.g. manual removal, of the divider assembly from the insulation body. A removable divider assembly may allow to check or monitor the divider assembly and the insulation body.

Where the plurality of impedance elements is encapsulated in an electrically insulating encapsulation body, a conductive layer may be applied on the outer surface of the encapsulating material to form a shielding of the impedance elements. Conventionally, this shielding layer or "screen" is held on electrical ground. A screen on electrical ground, however, causes parasitic currents through the encapsulation body, between impedance elements on higher voltage and the screen. Parasitic currents are undesired, because they can reduce the accuracy of the voltage sensing, in particular because their magnitude may vary uncontrollably with temperature and/or humidity of the encapsulation body.

Since an impedance element close to the high-voltage portion (i.e. the portion comprising the high-voltage contact) of the divider assembly is on a higher voltage than an impedance element close to the opposed low-voltage portion (i.e. the portion comprising the low-voltage contact) of the divider assembly, the voltage difference between impedance elements and the screen varies along the extension of the divider assembly, and from one impedance element to an adjacent impedance element, and so vary the resulting parasitic currents. A higher voltage difference normally results in higher parasitic currents towards/from the screen.

In an attempt to reduce these parasitic currents, it has been found that it is advantageous to split the screen into two conductive portions, separated by an intermediate insulating gap: A low-voltage screen portion is applied on the outer surface of the encapsulation body enveloping the low-voltage impedance elements, and is held on electrical ground or on a low voltage, while a high-voltage screen portion is applied on the outer surface of the encapsulation body enveloping the high-voltage impedance elements, and is held on high voltage.

As a result, some or all of the impedance elements of the low-voltage portion are shielded by a screen on electrical ground or on low voltage, which reduces voltage differences and parasitic currents. Similarly, some or all of the impedance elements in the high-voltage portion are shielded by a screen on high voltage, which reduces voltage differences and parasitic currents in the high-voltage portion of the plurality of impedance elements.

In certain advantageous embodiments, a first half of the number of discrete impedance elements of the plurality of discrete impedance elements, this first half forming the low-voltage portion of the divider assembly, are shielded by a screen held on electrical ground or on a low voltage. In certain of these advantageous embodiments, a second half of the number of discrete impedance elements of the plurality of discrete impedance elements, this second half forming the low-voltage portion of the divider assembly, are shielded by a screen held on elevated voltage.

An intermediate portion of the outer surface of the encapsulation body, namely a portion enveloping the intermediate portion of the plurality of impedance elements between the high-voltage portion and the low-voltage portion of the plurality of impedance elements, is not provided with a screen. This unshielded gap is necessary to avoid electrical discharges between the high-voltage portion of the screen and the low-voltage portion of the screen.

So generally, in certain embodiments of the sensor mat according to the present disclosure, in which the divider assembly comprises an electrically insulating encapsulation body encapsulating the plurality of impedance elements, an outer surface of the encapsulation body comprises a first surface region covered with a first electrically conductive layer for being connected to elevated voltage for shielding a portion of the divider assembly, a second surface region covered with a second electrically conductive layer for being connected to electrical ground or to a low voltage for shielding a portion of the divider assembly, and a third surface region, electrically insulating and free of an electrically conductive layer, arranged between the first surface region and the second surface region, for insulating the first electrically conductive layer from the second electrically conductive layer.

The first surface region may be arranged and sized such as to form a conductive envelope around the low-voltage portion of the plurality of impedance elements. The second surface region may be arranged and sized such as to form a conductive envelope around the high-voltage portion of the plurality of impedance elements.

In a specific embodiment, in which the divider assembly has an elongated shape and in which the plurality of impedance elements is entirely encapsulated in an electrically insulating encapsulation body, and in which the low-voltage portion and the high voltage portion are arranged at opposed end portions of the divider assembly, the first surface region of the encapsulation body is covered with an electrically conductive layer for being connected to high voltage, which envelopes the high-voltage portion of the plurality of impedance elements. The second surface region of the encapsulation body is covered with an electrically conductive layer for being connected to low voltage or electrical ground, which envelopes the low-voltage portion of the plurality of impedance elements. In a central surface region of the encapsulation body, enveloping the middle portion of the plurality of impedance elements, between the first and the second surface region, there is no conductive layer, and this electrically insulating gap separates the first surface region and the second surface region from each other.

A sensor mat as described herein may be considered very useful in combination with accessories for MV/HV power cables, such as cable terminations, cable splices or pluggable cable connectors, because it may allow for sensing a voltage in the vicinity of the accessory while facilitating fixation to a support surface of the accessory itself. The sensor mat may, for example, be affixed to an outer surface of a termination or to the surface of a power cable. The present disclosure therefore also provides a power cable accessory, such as a termination or a pluggable connector, comprising a support surface on which a sensor mat as described herein is affixed such that the outer mounting surface of the insulation body is affixed to the support surface of the power cable accessory.

This disclosure further provides a power distribution network, such as a national grid, comprising a MV/HV power cable and a power cable accessory as described in the preceding paragraph, mounted on the MV/HV power cable.

The sensor mat of the present disclosure can generally be made in different ways. One way is to first provide a mat-shaped insulation body as described herein, having a suitably shaped cavity, and then to accommodate a divider assembly in the cavity. Another way is to provide a divider assembly as described herein (in an encapsulation body or not), and to overmold the divider assembly with an insulating material that, after solidifying, forms the mat-shaped flexible insulation body as described herein, in which the divider assembly is embedded.

The present disclosure thus also provides a process of making a sensor mat as described herein, comprising the steps of:
i) providing a divider assembly comprising a plurality of discrete impedance elements, electrically connected in series with each other such as to be operable as a voltage divider for sensing a voltage of a MV/HV power conductor in a power distribution network,
ii) molding an electrically insulating material around the divider assembly, such that, after molding, the material forms an electrically insulating and flexible insulation body in which the divider assembly is embedded, and which comprises a mounting surface for affixing the sensor mat to a support surface.

The invention will now be described in more detail with reference to the following Figures exemplifying particular embodiments of the invention:
- Fig. 1: Perspective view of a first sensor mat according to the present disclosure;
- Fig. 2: Perspective view of the first sensor mat, affixed to a surface of a cable, and comprising a first divider asembly;
- Fig. 3: Perspective view of a second divider assembly, usable in a sensor mat according to the present disclosure;
- Fig. 4: Perspective view of a third divider assembly comprising an encapsulation body, usable in a sensor mat according to the present disclosure;
- Fig. 5: Longitudinal sectional view of a fourth divider assembly comprising an encapsulation body and a split screen, usable in a sensor mat according to the present disclosure; and
- Fig. 6: Perspective view of a second sensor mat according to the present disclosure, affixed to a cable termination on a power cable.

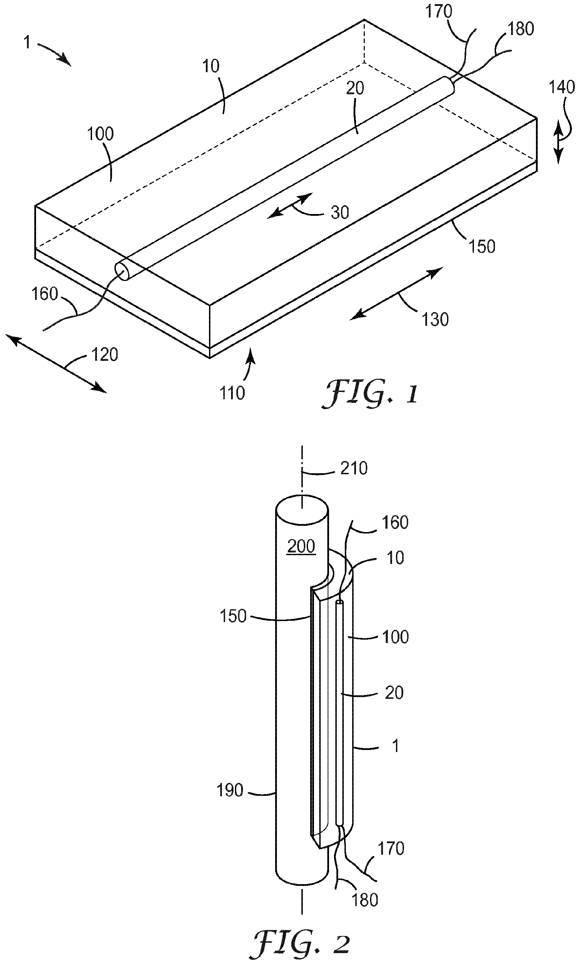

**Figure 1** is an illustration, in perspective view, of a first sensor mat 1 according to the present disclosure. The first sensor mat 1 comprises a flexible insulating body 10 and a first divider assembly 20, embedded in the insulation body 10. The insulation body 10 has the shape of a mat, being delimited by a flat first major surface 100 and an opposed, parallel flat second major surface 110, which is not visible in Figure 1 because it is located at the bottom of the insulation body 10. The major surfaces 100, 110 extend in width directions 120 and length directions 130, and are spaced from each other in a thickness direction 140. The thickness of the sensor mat 1 is considerably smaller than its length and width. The second major surface 110 forms a flat outer mounting surface 110 of a rectangular contour of the sensor mat 1, via which the sensor mat 1 can be affixed on a support surface.

The outer mounting surface 110 comprises a layer 150 of a pressure-sensitive adhesive. The adhesive layer 150 is shown exposed and ready to be affixed to a support surface. However, until shortly before use the adhesive layer 150 may be protected by a liner (not shown).

The insulation body 10 is a molded body of silicone, overmolded over the divider assembly 20. After solidifying, the insulation body 10 is solid, but flexible and can be bent and flexed.

The first divider assembly 20 has the shape of an elongated, cylindrical rod. It is arranged such that its long direction 30 extends in the length direction 130 of the mat. The divider assembly 20 is completely embedded in the insulation body 10.

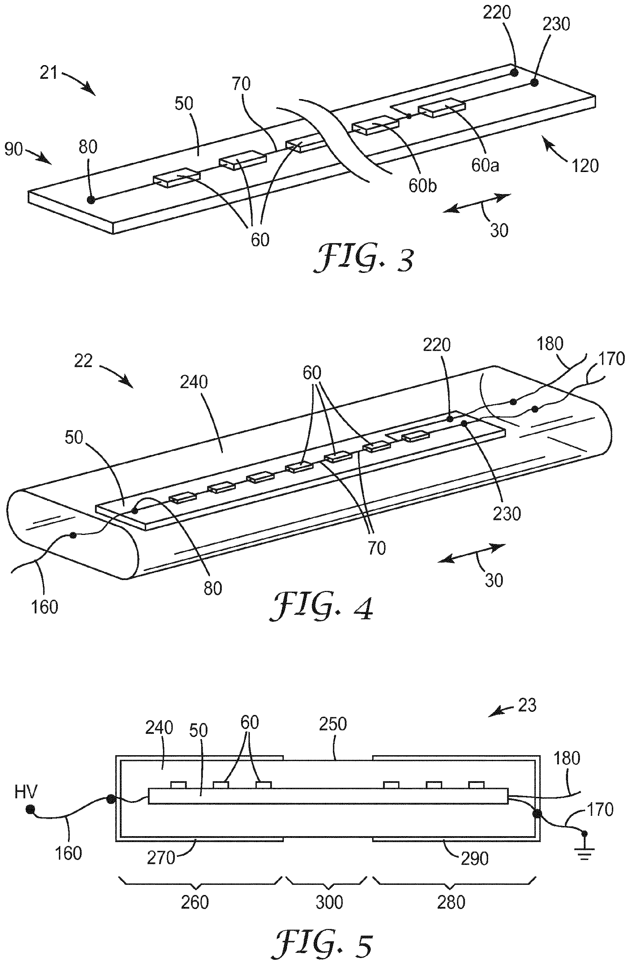

The divider assembly 20 comprises a plurality of discrete impedance elements, electrically connected in series with each other such as to be operable as a voltage divider for sensing a voltage of a MV/HV power conductor in a power distribution network, as will be explained below in the context of Figures 3 and 4. The discrete impedance elements are encapsulated: The divider assembly 20 comprises an electrically insulating encapsulation body in which the impedance elements are encapsulated, as described below. The encapsulating body is solid and rigid.

Three wires 160, 170, 180 connect the divider assembly 20 electrically and lead through the insulation body 10: A high-voltage wire 160 for electrical connection of the divider assembly 20 to a power conductor for sensing the voltage of the MV/HV power conductor, a ground wire 170 for electrical connection of the divider assembly 20 to electrical ground, and a signal wire 180 for transmitting a signal voltage, indicative of the voltage of the MV/HV power conductor, from the divider assembly 20 to the outside of the insulation body 10.

In Figure 1, the insulating body 10 is drawn as if it were transparent, in order for the Figure to be clearer. In reality, the insulating body 10 is typically opaque, although it might alternatively be transparent or translucent.

**Figure 2** shows, in a further perspective view, the first sensor mat 1 affixed to an outer surface 200 of a cylindrical element 190. The outer surface forms a support surface 200 for the sensor mat 1. The insulation body 10 is flexible enough to be wrapped around a portion (about one third) of the circumference of the cylindrical element 190.

Since the elongated first divider assembly 20 comprises the rigid encapsulation body, the divider assembly 20 is not flexible. For that reason, the sensor mat 1 can only be flexed or bent one-dimensionally in width direction 120, so that the central axis 210 of the curvature of the bent sensor mat 1 is parallel to the long extension of the divider assembly 20.

In its bent or flexed state, the insulation body 10, and with it the sensor mat 1, is affixed to the surface 200 of the element 190 via the adhesive layer 150 sticking to the surface 200.

The perspective view of **Figure 3** illustrates a second divider assembly 21 before embedding into an insulation body 10. Different from the first divider assembly 20, the second divider assembly 21 does not comprise an encapsulation body. The second divider assembly 21 comprises a plurality of discrete resistors 60, i.e. discrete impedance elements 60, electrically connected in series with each other such as to be operable as a voltage divider.

The second divider assembly 21 comprises a flexible PCB 50, on which the resistors 60 are mounted. The resistors 60 are electrically connected in series by conductive traces 70 on the PCB 50, so that they can be operated as a voltage divider. The resistors 60 form a straight chain.

The second divider assembly 21 does not comprise an encapsulation body. The flexibility of the PCB 50 provides that when the second divider assembly 21 is embedded in a flexible insulation body, like the insulation body 10 shown in Figure 1 and 2, the resulting sensor mat may be flexible in both directions, i.e. it can be flexed such that the sensor mat 1 can be flexed or bent two-dimensionally in width direction 120 and in length direction 130, so that the central axis 210 of the curvature of the bent sensor mat 1 is parallel or orthogonal to the long extension 30 of the divider assembly 21.

Close to a left-hand first end portion 90 of the divider assembly 21, the leftmost resistor 60 in Figure 3 is connected to a high-voltage contact 80, which facilitates electrical connection of the chain of resistors 60 to the high voltage of a power conductor. Similarly, close to the opposed second end portion 120, on the right side in Figure 3, the rightmost resistor 60a is connected to a low-voltage contact 230, which facilitates electrical connection of the chain of resistors 60 to low voltage, e.g. to electrical ground.

At its second end portion 120, the second divider assembly 21 has a midpoint access contact 220 for picking up a divided voltage from the voltage divider formed by the plurality of resistors 60. The midpoint access contact 220 is electrically connected between the rightmost resistor 60a and the resistor 60b adjacent to the rightmost resistor 60a. When the high-voltage contact 80 is electrically connected to the alternating elevated voltage of the power conductor, and the low-voltage contact 230 is connected to electrical ground, the voltage at the midpoint access contact 220 changes proportionally to the elevated voltage. The proportionality factor depends on the divider ratio of the voltage divider, i.e. on the total resistance on one side of the midpoint access contact 220 versus the resistance of the rightmost resistor 60a. By suitably choosing the resistances of the individual resistors 60 and of the rightmost resistor 60a on the other side of the midpoint access contact 220, the divider ratio can be adjusted for the voltage divider to yield a suitable output voltage at the midpoint access contact 220.

Wires can be connected to the high-voltage contact 80, to the low-voltage contact 230 and to the midpoint access contact 220 by which the respective voltages can be made accessible outside the insulation body 10.

Instead of using resistors 60, alternative voltage dividers can be made using other types of discrete impedance elements, like capacitors or of inductances, electrically connected in series, or even mixtures of such discrete impedance elements. The actual choice will depend on the requirements, e.g. a required frequency stability of the divider ratio. The term "impedance element" is used in this disclosure collectively as a general term for capacitors, resistors and inductances.

As described above, also the second divider assembly 21 can be embedded in a flexible insulation body 10, e.g. by overmolding the second divider assembly 21 with a liquid or viscous insulating material, which is poured over and around the divider assembly 21 and which is then caused to dry and solidify to form the insulation body 10.

**Figure 4** is a further perspective view, illustrating a third divider assembly 22 for use in a sensor mat according to the present disclosure. It is identical to the second divider assembly 21 of Figure 3, except that it comprises a solid encapsulation body 240, in which the discrete impedance elements, i.e. the discrete resistors 60, and the PCB 50 are encapsulated.

The encapsulation body 240 is made of a hardened resin. The PCB 50 with the resistors 60 and the conductive traces 70 on it is submerged in the resin while the resin is liquid. The resin is then allowed to solidify and harden, so that it forms the solid encapsulation body 240. For clarity, the encapsulation body 240 is shown transparent in Figure 4, but the encapsulation body 240 may actually be transparent, translucent, or opaque. The resin is a thermosetting material comprising Polyurethane. Alternatively, it is contemplated to use other resins like, for example, epoxy-based thermosetting materials or thermoplastic materials comprising Polyethylene or Polypropylene.

Advantageously, wires or other conductors are electrically connected to the chain of resistors 60 and led to outside the encapsulation body 240, so that the resistors 60 can be electrically contacted outside of the encapsulation body 240 in order for them to be operable as a voltage divider. In the third divider assembly 22 shown in Figure 4, a ground wire 170 is connected to the low-voltage contact 230, a signal wire 180 is connected to the midpoint access contact 200, and a high-voltage wire 160 is connected to the high-voltage contact 80. The high-voltage wire 160 is for ohmic connection to the inner conductor of a power cable.

It is apparent that also the chain of resistors 60 of the third divider assembly 22 shown in Figure 4 can be encapsulated in an encapsulation body similar to the encapsulation body 240 of the third divider assembly 22.

Generally, and independent of this specific embodiment, an encapsulation body 240 can provide mechanical stability to divider assemblies, e.g. to the third divider assembly 22, so that the risk of damage is reduced when mechanical forces are exerted on the sensor mat 1.

As an alternative to overmolding the divider assembly 20 with material that forms the elastic insulation body 10 after solidifying, a sensor mat according to the present disclosure can be assembled by providing an elastic mat-shaped insulation body which has a flat pouter mounting surface and a suitably shaped cavity to accommodate a divider assembly, such as one of the divider assemblies 20, 21, 22. For assembling a sensor mat, the divider assembly can then be pushed into that cavity.

Suitably encapsulated divider assemblies, such as the divider assembly 22 of Figure 4, are less likely to break when pushed into an insulation body 10. An encapsulation body can also provide a smooth outer surface to a divider assembly, e.g. to the divider assembly 22, so that there are a smaller number of air voids and smaller air voids in the space between the divider assembly 22 and the inner wall of the insulation body after insertion of the encapsulated divider assembly into the insulation body 10. A smooth outer surface of a divider assembly 22 generally makes insertion into an insulation body 10 easier.

The accuracy of the voltage sensing can be improved by electrically shielding the divider assembly. Where the divider assembly comprises an encapsulation body, such as the encapsulation body 240 in Figure 4, this can be done, for example, by providing the entire outer surface of the encapsulation body with an electrically conductive shielding layer or "screen", and connect this shielding layer, e.g. to electrical ground. As described above, it may be advantageous to split the screen into two portions, separated by an intermediate insulating gap.

**Figure 5** shows, in a longitudinal sectional view, a fourth divider assembly 23. It is identical to the third divider assembly 22 of Figure 4, except that it that is equipped with a "split screen" on the outer surface of its encapsulation body 240.

In length direction 30 of the elongate divider assembly 23, the outer surface 250 of the encapsulation body 240 is subdivided into three regions: A first surface region 260, which is covered with a first electrically conductive layer 270, made of copper. The first conductive layer 270 extends circumferentially around, and thereby envelopes, the high-voltage portion, i.e. the left-hand side portion (in Figure 5) of the divider assembly 23. The first conductive layer 270 is connected to the elevated voltage of the power conductor via the high-voltage wire 160.

A second surface region 280 of the encapsulating body 240, spaced from the first surface region 260 in length direction 30, is covered with a second electrically conductive copper layer 290. The second conductive layer 290 extends circumferentially around, and thereby envelopes, the low-voltage portion, i.e. the right-hand side portion (in Figure 5) of the fourth divider assembly 23. The second conductive layer 290 is connected to electrical ground via the ground wire 170.

A third surface region 300 is arranged lengthwise between the first surface region 260 and the second surface region 280 of the encapsulating body 240. The third surface region 300 is electrically insulating, and here is no conductive layer in this third surface region 300. It forms a non-conductive gap between the first surface region 260 and the second surface region 280, and thereby electrically insulates the first surface region 260 and the second surface region 280 from each other. No impedance elements 60 are arranged below the third surface region 300.

In Figure 5, the third surface region 300 is shown as uncovered. Alternatively, it could be covered with an electrically insulating layer. The extension of the third surface region 300 in length direction 30, i.e. the width of the insulating gap, can be chosen according to the actual circumstances and appropriately for avoiding electrical discharges between the first conductive layer 270 and the second conductive layer 290, across the insulating gap 300.

Where the elevated voltage of the power conductor is about 20 kV, and the divider assembly 23 with its encapsulating body 240 is overmolded in an insulating body 10 of silicone rubber, the width of the insulating gap 300 can be, for example, around 50 mm. For lower voltages, the insulating gap 300 can be narrower, for higher voltages it is preferably wider. Where there is no insulation body 10 fitted tightly around the divider assembly 23 with its encapsulation body 240, the insulating gap 300 should normally be wider to reduce the risk of discharges.

The electrically conductive layers 270, 290 of the respective portions of the split screen can, for example, be formed by thin layers of copper, vapour-deposited on the respective surface portions 260, 280 of the outer surface 250 of the encapsulating body 240.

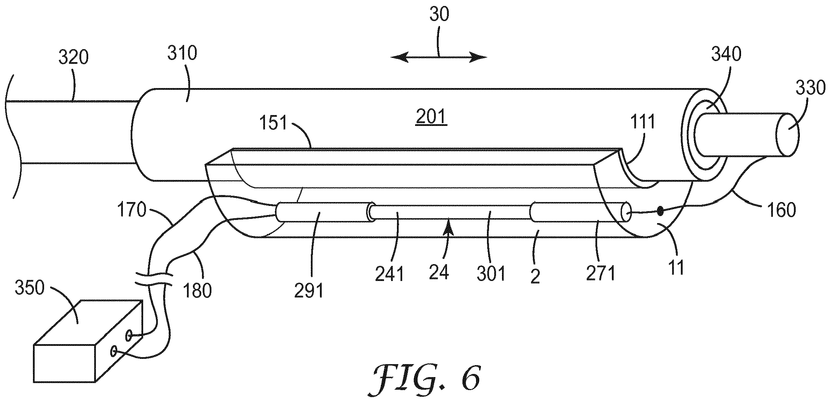

**Figure 6** illustrates, in a perspective view, a second sensor mat 2 according to the present disclosure, affixed to a cable termination 310 on the end of a power cable 320 in a power distribution network of a national grid.

The end of the power cable 320 has been gradually stripped down, so that the inner conductor 330, the main insulation layer 340 and a semiconductive layer (not shown) of the cable 320 are exposed. The termination 310 consists of a shrinkable elastic tube of an insulating rubber material. It has been shrunk down over the last portion of the main insulation layer 340 and over a portion of a semiconductive layer of the cable 320, which covers the main insulation layer 340.

The sensor mat 2 comprises a flexible, mat-shaped insulation body 11. Its mounting surface 111 is flat when the not bent around the cable termination 310. The mounting surface 111 is formed by a layer 151 of pressure-sensitive adhesive, by which the sensor mat 2 is affixed to the outer surface 201 of the termination 310. The sensor mat 2 is applied circumferentially around the cable termination 320, covering about half of the circumference of the termination 320.

The sensor mat 2 further comprises an elongated, rod-shaped fifth divider assembly 24, similar to the fourth divider assembly 23 of Figure 5, embedded in the insulation body 11. The fifth divider assembly 24 comprises a rigid encapsulation body 241 of a hardened resin, in which a PCB (not shown) and a plurality of discrete capacitors (not shown), electrically connected in series with each other, similar to the PCB 50 and the discrete resistors 60 of Figures 3 and 4, are encapsulated.

The divider assembly 24 is provided with a split screen as explained in the context of Figure 5, with a first conductive copper layer 271 being applied on a first surface region of the encapsulation body 241 and enveloping a high-voltage portion, i.e. the right-hand side portion (in Figure 6) of the divider assembly 24, and a second conductive copper layer 291 being applied on a second surface region of the encapsulation body 241 and enveloping a low-voltage portion, i.e. the left-hand side portion, of the divider assembly 24. The conductive layers 271, 291 are separated, in length direction 30 of the divider assembly 24, by a non-conductive surface region 301 forming an insulating gap between the first conductive copper layer 271 and the second conductive copper layer 291.

The fifth divider assembly 24 is electrically connected by wires: At the high voltage portion of the divider assembly, a high-voltage wire 160 connects the plurality of capacitors in the divider assembly 24 with the central conductor 330 on elevated voltage. The high-voltage wire 160 runs from the high-voltage contact 80 on the PCB 50 of the divider assembly 24 through the encapsulation body 241 and through the insulation body 11 to electrically contact the exposed inner conductor 330. At the opposite, low-voltage portion of the divider assembly, a ground wire 170 and a signal wire 180 are routed, from the PCB 50 through the encapsulation body 241 and through the insulation body 11, to an external processing box 350. This processing box 350 provides electrical ground to the divider assembly 24 through the ground wire 170, and processes the signal voltage on the signal wire 180 to determine the actual voltage of the inner conductor 330 versus electrical ground.

## Claims

1. Sensor mat (1, 2) comprising an electrically insulating, flexible insulation body (10, 11) and a divider assembly (20, 21, 22, 23, 24), embedded in the insulation body, wherein the divider assembly comprises a plurality of discrete impedance elements (60), electrically connected in series with each other such as to be operable as a voltage divider for sensing a voltage of a MV/HV power conductor (320) in a power distribution network,
**characterized in that** the insulation body has the shape of a mat and comprises an outer mounting surface (110, 111) for affixing the sensor mat on a support surface (200, 201).

2. Sensor mat according to claim 1, further comprising a skirt, protruding from a major surface (100) of the insulation body (10, 11), for reducing creepage currents over that major surface.

3. Sensor mat according to any one of the preceding claims, wherein the outer mounting surface (110, 111) is formed by a layer of adhesive (150, 151).

4. Sensor mat according to any one of the preceding claims, wherein the insulation body (10, 11) is a molded body and comprises a cavity for accommodating the divider assembly (20, 21, 22, 23, 24) therein.

5. Sensor mat according to claim 4, wherein the insulation body (10, 11) is a molded body, overmolded over the divider assembly (20, 21, 22, 23, 24).

6. Sensor mat according to any one of the preceding claims, wherein the insulation body (10, 11) has a rectangular contour delimited by at least one straight edge, and wherein the divider assembly (20, 21, 22, 23, 24) has an elongated shape defining a length direction (30) and is arranged such that its length direction is oriented parallel to the straight edge.

7. Sensor mat according to any one of the preceding claims, wherein the divider assembly (20, 21, 22, 23, 24) comprises a high-voltage wire (160), electrically connected to the plurality of discrete impedance elements (60), for electrically connecting the discrete impedance elements to the power conductor (320).

8. Sensor mat according to any one of the preceding claims, wherein the discrete impedance elements (60) are discrete capacitors.

9. Sensor mat according to any one of the preceding claims, wherein the divider assembly (20, 21, 22, 23, 24) comprises a printed circuit board (50) for supporting the plurality of discrete impedance elements (60).

10. Sensor mat according to any one of the preceding claims, wherein the divider assembly (20, 21, 22, 23, 24) comprises an electrically insulating encapsulation body (240, 241), in which the plurality of discrete impedance elements (60) is encapsulated.

11. Sensor mat according to claim 10, wherein the encapsulation body (240, 241) is transparent for allowing visual inspection of the plurality of discrete impedance elements (60), or wherein the encapsulation body (240, 241) is opaque for prohibiting visual inspection of the plurality of discrete impedance elements (60).

12. Sensor mat according to claims 10 or 11, wherein an outer surface (250) of the encapsulation body (240, 241) comprises
- a first surface region (260) covered with a first electrically conductive layer (270, 271) for being connected to elevated voltage for shielding a portion of the divider assembly (20, 21, 22, 23, 24);
- a second surface region (280) covered with a second electrically conductive layer (290, 291) for being connected to electrical ground for shielding a portion of the divider assembly; and
- a third surface region (300, 301), electrically insulating and free of an electrically conductive layer, arranged between the first surface region (260) and the second surface region (280), for insulating the first electrically conductive layer (270, 271) from the second electrically conductive layer (290, 291).

13. Power cable accessory, such as a termination (310) or a pluggable connector, comprising a support surface (200, 201) on which a sensor mat (1, 2) according to any one of the preceding claims is affixed such that the outer mounting surface (110, 111) of the insulation body (10, 11) is affixed to the support surface (200, 201) of the power cable accessory.

14. Power distribution network, such as a national grid, comprising a MV/HV power cable (320) and a power cable accessory (310) according to claim 13, mounted on the MV/HV power cable.

15. Process of making a sensor mat (1, 2) according to claim 1, comprising the steps of:
i) providing a divider assembly (20, 21, 22, 23, 24) comprising a plurality of discrete impedance elements (60), electrically connected in series with each other such as to be operable as a voltage divider for sensing a voltage of a MV/HV power conductor (320) in a power distribution network; and
ii) molding an electrically insulating material around the divider assembly, such that, after molding, the material forms an electrically insulating and flexible insulation body (10, 11) in which the divider assembly is embedded, and which comprises a mounting surface (110) for affixing the sensor mat to a support surface (200, 201).
